# EUROPEAN PATENT SPECIFICATION

(11) **EP 3 514 899 B1**
(45) Date of publication and mention of the grant of the patent: **26.07.2023**
(21) Application number: 17850861.0
(22) Date of filing: 12.09.2017
(51) Int. Cl.: H01T 4/08, H02B 13/035, H01C 7/12, H01T 1/16, H01T 21/06, H01H 3/42, H01H 3/46

(54) **LIGHTNING ARRESTER**
BLITZABLEITER
PARAFOUDRE

(30) Priority: 16.09.2016 JP 2016181891
(43) Date of publication of application: 24.07.2019
(73) Proprietor: Kabushiki Kaisha Toshiba, Minato-ku Tokyo 105-8001 (JP); Toshiba Energy Systems & Solutions Corporation, Kawasaki-shi, Kanagawa 212-0013 (JP)
(72) Inventor: KUBO, Katsutaka, Kawasaki-shi, Kanagawa (JP); MIZUTANI Manabu, Kawasaki-shi Kanagawa 210-0862 (JP); FUKANO Takato, Kawasaki-shi, Kanagawa (JP); FUJIWARA Kaneharu, Tokyo 105-8001 (JP); OKANARI Nobuaki, Kawasaki-shi, Kanagawa (JP)
(74) Representative: Henkel & Partner mbB
(86) International application number: PCT/JP2017/032746
(87) International publication number: WO 2018/051959

(56) References cited:
- EP-A1- 2 690 314
- EP-A1- 2 854 141
- EP-A1- 3 001 430
- WO-A1-2014/050184
- WO-A1-2014/173461
- DE-A1-102011 077 394
- JP-A- H0 492 382
- JP-A- S6 387 111
- JP-A- H02 211 011
- JP-U- S 637 905
- JP-U- H0 186 416

## Description

### TECHNICAL FIELD OF INVENTION

An embodiment of the present invention relates to a surge arrester.

### BACKGROUND ART

A gas-insulation switchgear is subjected to a withstand voltage test at its installed location. The test voltage of the withstand voltage test is higher than a voltage applicable to a surge arrester. Thus, the withstand voltage test is carried out in a state where the surge arrester and the gas-insulation switchgear are electrically disconnected.

The electrical disconnection between the surge arrester and the gas-insulation switchgear is achieved by, e.g., removing the surge arrester from the gas-insulation switchgear. Alternatively, a disconnector is provided in the gas-insulation switchgear, and the disconnector is operated to achieve the electrical disconnection. An example of prior art surge arrester is disclosed in EP-A-2854141.

### CITATION LIST

### PATENT LITERATURE

PATENT LITERATURE 1: JP-T-2014-523639
PATENT LITERATURE 2: JP-U-6-080294
PATENT LITERATURE 3: JP 10-322822 A
PATENT LITERATURE 4: JP 09-233628 A
PATENT LITERATURE 5: DE 10 2011 077394 A1

### DISCLOSURE OF THE INVENTION

### PROBLEMS TO BE SOLVED BY THE INVENTION

In the former method, that is, when the surge arrester is removed from the gas-insulation switchgear, it is necessary to mount the surge arrester in the gas-insulation switchgear again after completion of the withstand voltage test. This may prolong the work time.

In the latter method, that is, when the disconnector is provided in the gas-insulation switchgear, cost may be increased.

The object of the present invention is to provide a surge arrester capable reducing the work time required for the withstand voltage test and reducing the cost of the entire gas-insulation switchgear.

### MEANS FOR SOLVING PROBLEMS

Accordingly, there is provided a surge arrester as outlined in independent claim 1. Advantageous developments are defined in the dependent claims.

### BRIEF DESCRIPTION OF DRAWINGS

[FIG. 1] FIG. 1 is a cross-sectional view illustrating a surge arrester 1 according to an embodiment of the present invention;
[FIG 2] FIG. 2 is a cross-sectional view illustrating the surge arrester 1 according to the embodiment of the present invention;
[FIG. 3] FIG. 3 is a cross-sectional view illustrating the surge arrester 1 according to the embodiment of the present invention;
[FIG 4] FIG. 4 is a cross-sectional view illustrating the surge arrester 1 according to the embodiment of the present invention;
[FIG. 5] FIG. 5 is a cross-sectional view illustrating the surge arrester 1 according to the embodiment of the present invention; and
[FIG 6] FIG. 6 is a cross-sectional view illustrating the surge arrester 1 according to a modification of the embodiment.

### DESCRIPTION OF EMBODIMENTS

### [Configuration]

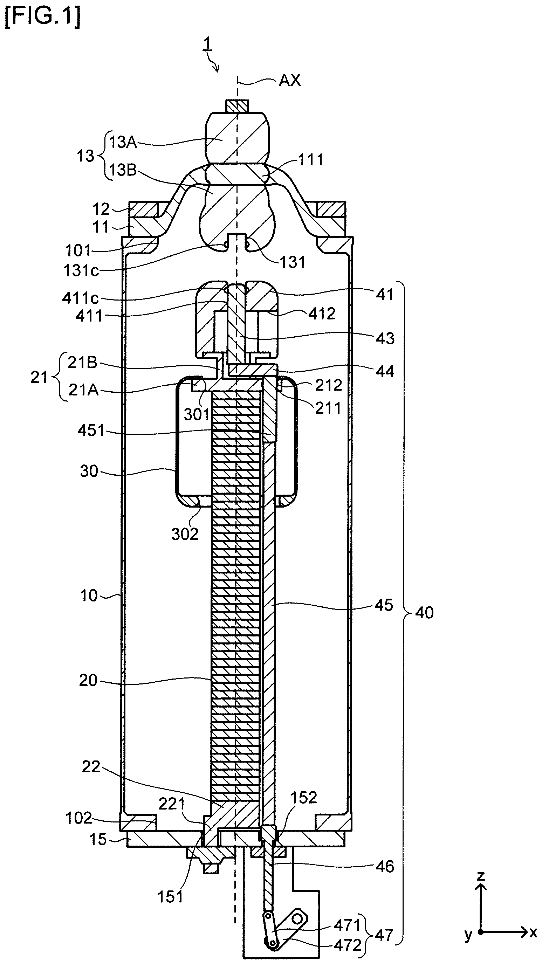

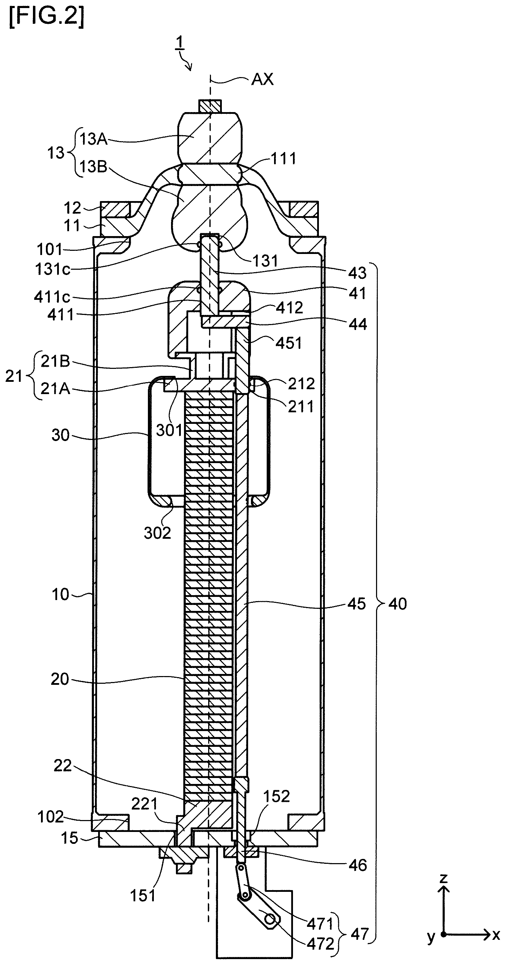

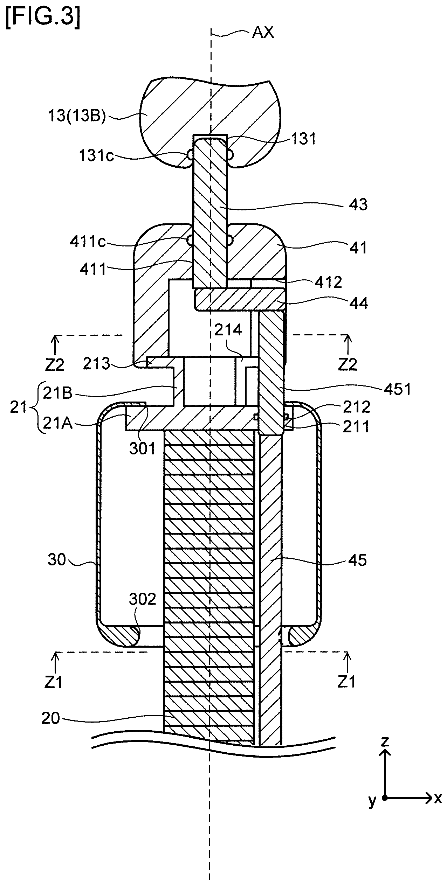

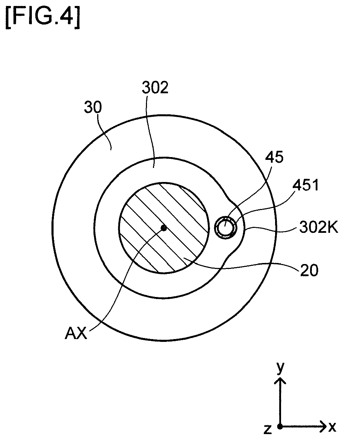

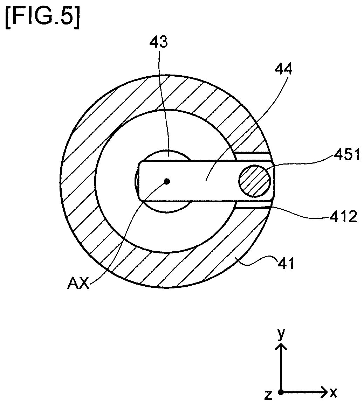

FIGS. 1 to 5 are cross-sectional views illustrating a surge arrester 1 according to an embodiment of the present invention. FIGS. 1 to 3 illustrate the vertical surface (xz plane) of the surge arrester 1 extending along the vertical direction z. The surge arrester 1 according to the present embodiment is a tank-shaped surge arrester installed in a gas-insulation switchgear (not illustrated). In FIG. 1, the state of the surge arrester 1 when the gas-insulation switchgear is subjected to a withstand voltage test is illustrated. On the other hand, FIG. 2 shows the state of the surge arrester 1 being used as a protecting device for protecting a gas-insulation switchgear from abnormal voltage (surge voltage) due to, e.g., lightning. FIG. 3 is a partially enlarged view of FIG 2. FIGS 4 and 5 illustrate the horizontal surface (xy plane) perpendicular to the vertical direction z of the surge arrester 1. FIG. 4 is a cross-sectional view taken along line Z1-Z1 in FIG. 3, and FIG 5 is a cross-sectional view taken along line Z2-Z2 in FIG 3.

In the present embodiment, the surge arrester 1 includes a grounded enclosure 10, a nonlinear resistor 20 (internal element), a shield 30, and a isolating device 40. Hereinafter, the parts constituting the surge arrester 1 will be sequentially described.

### (Grounded Enclosure 10)

The grounded enclosure 10 is a cylindrical tubular body made of a metal material and is installed such that a center axis AX (tube axis) extends in the vertical direction z. The grounded enclosure 10 has a tank upper opening 101 at the upper surface thereof and a tank lower opening 102 at the lower surface thereof.

In the grounded enclosure 10, the tank upper opening 101 is closed by an insulating spacer 11, a ring 12, and a high-voltage side terminal part 13 (high-voltage side conductor) which are provided at the upper surface of the grounded enclosure 10.

The insulating spacer 11 is a disk-shaped member having the center part thereof protruding outward and is installed coaxially with the grounded enclosure 10. That is, the center axis (not illustrated) of the insulating spacer 11 coincides with the center axis AX of the grounded enclosure 10. The ring 12 is installed so as to surround the center portion of the insulating spacer 11, whereby the insulating spacer 11 is fixed to the upper side of the grounded enclosure 10. A metal conductor 111 is provided at the center portion of the insulating spacer 11, and an insulating body such as epoxy resin is formed around the metal conductor 111. The insulating spacer 11 may have a shape in which the center portion thereof protrudes inward.

The high-voltage side terminal part 13 includes a first high-voltage side terminal component 13A and a second high-voltage side terminal component 13B. The first high-voltage side terminal component 13A and the second high-voltage side terminal component 13B are conductors each having a horizontal surface that is perpendicular to the center axis AX of the grounded enclosure 10 and circular in cross section. The first and second high-voltage side terminal components 13A and 13B are installed coaxially with the grounded enclosure 10.

The first high-voltage side terminal component 13A of the high-voltage side terminal part 13 is installed on the upper surface of the metal conductor 111 provided at the center of the insulating spacer 11. The first high-voltage side terminal component 13A is electrically connected, at its upper-side portion, to the bus line (not illustrated) of the gas-insulation switchgear.

The second high-voltage side terminal component 13B of the high-voltage side terminal part 13 is installed on the lower surface of the metal conductor 111. The first high-voltage side terminal component 13A and the second high-voltage side terminal component 13B are fixed to the metal conductor 111 using, e.g., a bolt (not illustrated) and thus electrically connected to each other through the metal conductor 111. A concave part 131 is formed in the surface on the lower end (the other end) of the second high-voltage side terminal component 13B, and a first contact 131c is provided along the inner peripheral surface of the concave part 131.

The tank lower opening 102 of the grounded enclosure 10 is closed by a bottom plate 15 provided at the lower surface of the grounded enclosure 10.

The bottom plate 15 is a disk-shaped conductor through which a first bottom plate through hole 151 and a second bottom plate through hole 152 penetrate in the vertical direction z. The first bottom plate through hole 151 and the second bottom plate through hole 152 are not formed coaxially with the grounded enclosure 10 but formed at an eccentric position from the center axis AX of the grounded enclosure 10. Although details will be described later, a ground side terminal part 221 is inserted through the first bottom plate through hole 151, and an operating rod 46 constituting the isolating device 40 is inserted through the second bottom plate through hole 152.

As described above, the insulating spacer 11 and high-voltage side terminal part 13, and the like are provided on the upper end (one end) side of the grounded enclosure 10, and the bottom plate 15, ground side terminal part 221, and the like are provided on the other end side thereof, whereby the grounded enclosure 10 has a hermetically sealed inner space. Insulation gas (not illustrated) such as SF₆ gas is encapsulated in the hermetically sealed space.

### (Nonlinear Resistor 20)

The nonlinear resistor 20 has a disk-like shape, and a plurality of the nonlinear resistors 20 are laminated in the vertical direction z. The nonlinear resistor 20 is an element mainly including, e.g., zinc oxide. The nonlinear resistor 20 exhibits an insulation property when normal voltage acts thereon; while when abnormal voltage which is higher than the normal voltage acts on the nonlinear resistor 20, it is reduced in resistance value and thus exhibits a conductive property.

The laminate formed by laminating the plurality of nonlinear resistors 20 is housed inside the grounded enclosure 10 as an internal element of the surge arrester 1. The laminate of the nonlinear resistors 20 is coaxial with the grounded enclosure 10. The laminate has a high-voltage side electrode 21 (first electrode) on the upper end surface side and a ground side electrode 22 (second electrode) on the lower end surface side.

The high-voltage side electrode 21 includes a first high-voltage side electrode part 21A and a second high-voltage side electrode part 21B. The first high-voltage side electrode part 21A and the second high-voltage side electrode part 21B are integrally formed with each other.

The first high-voltage side electrode part 21A of the high-voltage side electrode 21 has a disk-like shape, installed coaxially with the grounded enclosure 10, and is larger in outer diameter than the nonlinear resistor 20. The first high-voltage side electrode part 21A has a high-voltage side electrode through hole 211 at the outer peripheral portion thereof positioned on the outer peripheral side of the center portion where the nonlinear resistor 20 is disposed. The high-voltage side electrode through hole 211 penetrates the first high-voltage side electrode part 21A in a direction along the center axis AX of the grounded enclosure 10. The high-voltage side electrode through hole 211 is not formed coaxially with the grounded enclosure 10 but formed in the high-voltage side electrode 21 at an eccentric position from the center axis AX of the grounded enclosure 10. A low-friction ring 212 is installed along the inner peripheral surface of the high-voltage side electrode through hole 211. The low-friction ring 212 is a ring member made of fluororesin such as polytetrafluoroethylene (PTFE) and has a friction coefficient smaller than that of the inner peripheral surface of the high-voltage side electrode through hole 211.

The second high-voltage side electrode part 21B of the high-voltage side electrode 21 is a cylindrical tubular body and is installed coaxially with the grounded enclosure 10. The second high-voltage side electrode part 21B is positioned on the upper surface side of the first high-voltage side electrode part 21A. The second high-voltage side electrode part 21B includes a flange part 213 at the upper surface portion thereof, and the flange part 213 is connected to a guide conductor 41. The second high-voltage side electrode part 21B has a high-voltage side electrode opening 214 at the peripheral surface portion thereof. The high-voltage side electrode opening 214 makes the inner space of the second high-voltage side electrode part 21B and the outer space thereof communicate with each other in the radial direction of the grounded enclosure 10.

The ground side electrode 22 is a disk-shaped conductor and is formed such that the ground side terminal part 221 protrudes downward. The ground side terminal part 221 is electrically connected to the ground side electrode 22 and is connected to a first bottom plate through hole 151 formed in the bottom plate 15. The ground side terminal part 221 is electrically connected to the earth (reference potential point).

### (Shield 30)

The shield 30 is a cylindrical tubular body made of a conductive material and is installed coaxially with the grounded enclosure 10. The shield 30 houses the upper side portion (high-voltage side) of the laminate of the nonlinear resistors 20 in the inner space thereof so as to make the distribution of voltage to be applied to the laminate of the nonlinear resistors 20 uniform in the lamination direction. The shield 30 has a shield upper side opening 301 and a shield lower side opening 302.

The shield upper side opening 301 is a circular opening formed at the upper surface portion of the shield 30, and the inner diameter of the shield upper side opening 301 is smaller than the outer diameter of the high-voltage side electrode 21. The shield 30 houses the high-voltage side electrode 21 in the inner space thereof and is supported on the upper surface of the high-voltage side electrode 21.

The shield lower side opening 302 is a circular opening formed at the lower surface portion of the shield 30, and the inner diameter of the shield lower side opening 302 is larger than the outer diameter of the nonlinear resistor 20. The laminate of the nonlinear resistors 20 and an insulating rod 45 of the isolating device 40 to be described later penetrate through the shield lower side opening 302. The shield lower side opening 302 has a notch 302K (see FIG. 4) at a portion through which the insulating rod 45 penetrates.

### (Isolating Device 40)

The isolating device 40 is configured to switch electrically disconnect (FIG 1) or electrically connect (FIG 2) between the high-voltage side terminal part 13 and the high-voltage side electrode 21. The isolating device 40 has a guide conductor 41, a movable rod 43, an eccentric member 44, an insulating rod 45, and an operating rod 46 inside the grounded enclosure 10 and has a rod operating part 47 outside the grounded enclosure 10. Details of the above members constituting the isolating device 40 will be described later.

### (Guide Conductor 41)

The guide conductor 41 (internal element side conductor) is a cylindrical tubular body and disposed coaxially with the grounded enclosure 10. Inside the grounded enclosure 10, the guide conductor 41 is disposed closer to the upper end side of the grounded enclosure 10 than the shield 30 is. The guide conductor 41 is supported by the high-voltage side electrode 21. The guide conductor 41 is electrically connected to the high-voltage side electrode 21. The guide conductor 41 faces the high-voltage side terminal part 13 in the vertical direction z with an interval interposed therebetween. The guide conductor 41 has a guide conductor through hole 411 and a guide conductor opening 412 which are formed therein.

The guide conductor through hole 411 is a through hole penetrating the upper surface portion of the guide conductor 41 that faces the high-voltage side terminal part 13 and is coaxial with the concave part 131 of the high-voltage side terminal part 13. The inner diameter of the guide conductor through hole 411 and the inner diameter of the concave part 131 formed in the high-voltage side terminal part 13 are equal to each other. A second contact 411c is provided along the inner peripheral surface of the guide conductor through hole 411.

The guide conductor opening 412 is an opening formed at the peripheral surface portion of the guide conductor 41 and makes the inside of the guide conductor 41 and the outside thereof communicate with each other in the radial direction (x-direction in FIG. 5) of the grounded enclosure 10.

### (Movable Rod 43)

The movable rod 43 is a columnar rod-like body made of a conductive material and is disposed coaxially with the grounded enclosure 10. That is, the movable rod 43 is disposed coaxially with the guide conductor through hole 411 formed in the guide conductor 41 and the concave part 131 formed in the high-voltage side terminal part 13.

Although details will be described later, the movable rod 43 can move in the vertical direction z together with the eccentric member 44, insulating rod 45 and operating rod 46 by the operation of the rod operating part 47. In this example, the movable rod 43 is inserted through the guide conductor through hole 411 of the guide conductor 41 and linearly slid and moved between the upper and lower end sides while being guided by the guide conductor 41 in the vertical direction z. When the movable rod 43 is moved upward in the vertical direction z, the upper end portion thereof is inserted inside the concave part 131 formed in the high-voltage side terminal part 13. On the other hand, when the movable rod 43 is moved to the lower end side, the movable rod 43 and the high-voltage side terminal part 13 are separated from each other.

### (Eccentric Member 44)

The eccentric member 44 is a plate-like member (link member) made of a conductive material and is disposed such that the longitudinal direction thereof extends in the radial direction (x-direction in FIG. 5) of the grounded enclosure 10. Inside the grounded enclosure 10, the eccentric member 44 connects the movable rod 43 and the insulating rod 45. In this example, the lower end portion of the movable rod 43 is connected to a part of the upper surface of the eccentric member 44 that is positioned at the center axis AX of the grounded enclosure 10, and the upper end portion of the insulating rod 45 is connected to a part of the lower surface of the eccentric member 44 that is positioned radially outside the center axis AX of the grounded enclosure 10.

When the movable rod 43 is moved in the vertical direction z, the eccentric member 44 is moved in the vertical direction z in a space including the guide conductor opening 412 and the high-voltage side electrode opening 214.

### (Insulating Rod 45)

The insulating rod 45 is a columnar rod-like body made of an insulating material. The insulating rod 45 is made of, e.g., fiber-reinforced plastic (FRP). Unlike the movable rod 43, the insulating rod 45 is not disposed coaxially with the grounded enclosure 10. The insulating rod 45 is disposed around the laminate of the nonlinear resistors 20 at an eccentric position from the center axis AX of the grounded enclosure 10 such that the center axis of the insulating rod 45 extends along the vertical direction z. That is, inside the grounded enclosure 10, the insulating rod 45 is disposed at an eccentric position eccentric with respect to the nonlinear resistor 20 and the movable rod 43.

The insulating rod 45 is disposed such that the upper side portion thereof is inserted through the high-voltage side electrode through hole 211. As described above, the insulating rod 45 is moved in the vertical direction z. A reinforcing part 451 is formed at the upper side portion of the insulating rod 45 where the outer peripheral surface of the rod 45 slides along the inner peripheral surface of the high-voltage side electrode through hole 211 when the rod 45 moves. The reinforcing part 451 is made of a metal material to reinforce the sliding portion of the insulating rod 45.

The outer peripheral surface of the insulating rod 45 contacts the low-friction ring 212 installed inside the high-voltage side electrode through hole 211, allowing the insulating rod 45 to be moved smoothly in the vertical direction z.

The insulating rod 45 is connected with the operating rod 46 at its lower end portion.

### (Operating Rod 46)

The operation rod 46 is a columnar rod-like body made of a metal material. Like the insulating rod 45, the operating rod 46 is disposed at an eccentric position from the center axis AX of the grounded enclosure 10 such that the center axis of the insulating rod 45 extends along the vertical direction z.

The operating rod 46 is inserted through the second bottom plate through hole 152. The upper end portion of the operating rod 46 is connected to the insulating rod 45, and the lower end portion thereof is connected to the rod operating part 47. At least a part of the operating rod 46 that slides with respect to the bottom plate 15 is made of a metal material for reinforcement.

### (Rod Operating Part 47)

The rod operating part 47 is installed outside the grounded enclosure 10. In this example, the rod operating part 47 is installed at the lower surface of the bottom plate 15.

The rod operating part 47 includes a plurality of link members (e.g., a first link member 471 and a second link member 472), and the plurality of link members are driven by a driver (not illustrated). With this configuration, the rod operating part 47 moves the eccentric member 44, insulating rod 45, and operating rod 46 between the upper end side and the lower end side to thereby move the movable rod 43 in the vertical direction z.

### (Action)

The action of the surge arrester 1 according to the present embodiment will be described.

### (Case Where Gas-insulation Switchgear Is Subjected to Withstand Voltage Test)

As illustrated in FIG. 1, when a gas-insulation switchgear is subjected to a withstand voltage test, the high-voltage side terminal part 13 and the high-voltage side electrode 21 are electrically disconnected in the surge arrester 1. In this case, in the isolating device 40, the rod operating part 47 moves the movable rod 43, eccentric member 44, insulating rod 45 and operating rod 46 to the lower end side. At this time, the movable rod 43 is guided along the guide conductor through hole 411 and linearly moved to the lower end side. As a result, the movable rod 43 is disconnected from the high-voltage side terminal part 13, and the upper end portion of the movable rod 43 is housed inside the guide conductor through hole 411.

As a result, the outer peripheral surface of the movable rod 43 does not contact the first contact 131c provided in the concave part 131 of the high-voltage side terminal part 13, but contacts the second contact 411c provided inside the guide conductor through hole 411. In this state, the gas-insulation switchgear connected to the high-voltage side terminal part 13 and the nonlinear resistor 20 connected to the high-voltage side electrode 21 are not electrically connected to each other, allowing the withstand voltage test to be carried out for the gas-insulation switchgear.

### (Case Where Surge Arrester 1 Is Used as Protecting Device for Gas-insulation Switchgear)

As illustrated in FIG. 2, when the surge arrester 1 is used as a protecting device for the gas-insulation switchgear, the high-voltage side terminal part 13 and the high-voltage side electrode 21 are electrically connected in the surge arrester 1. In this case, in the isolating device 40, the rod operating part 47 moves the movable rod 43, eccentric member 44, insulating rod 45 and operating rod 46 to the upper end side. As a result, the movable rod 43 is connected to the high-voltage side terminal part 13, and the upper end portion of the movable rod 43 is housed inside the concave part 131 formed in the high-voltage side terminal part 13.

As a result, the outer peripheral surface of the movable rod 43 contacts the second contact 411c provided inside the guide conductor through hole 411 and, at the same time, contacts the first contact 131c provided in the concave part 131 of the high-voltage side terminal part 13. In this state, the gas-insulation switchgear connected to the high-voltage side terminal part 13 and the nonlinear resistor 20 connected to the high-voltage side electrode 21 are electrically connected to each other, allowing the surge arrester 1 to be used as a protecting device for the gas-insulation switchgear.

### (Operation/Effect)

As described above, in the surge arrester 1 according to the present embodiment, the high-voltage side terminal part 13 electrically connected to the gas-insulation switchgear is installed on the upper end side of the grounded enclosure 10 in which insulation gas is encapsulated. Inside the grounded enclosure 10, the nonlinear resistor 20 having the high-voltage side electrode 21 on the upper end side thereof is housed. The high-voltage side terminal part 13 and the high-voltage side electrode 21 can be electrically connected or disconnected by the isolating device 40. Thus, in the present embodiment, when a withstand voltage test is carried out, it is possible to electrically disconnect the gas-insulation switchgear and the nonlinear resistor 20 by electrically disconnecting the high-voltage side terminal part 13 and the high-voltage side electrode 21 without involving treatment of insulation gas. As a result, according to the present embodiment, it is possible to reduce working time required for a withstand voltage test and to reduce cost.

In the present embodiment, the high-voltage side terminal part 13 has the concave part 131 on the lower end side thereof, as described above. The isolating device 40 has the guide conductor 41 formed such that the guide conductor through hole 411 faces the concave part 131 and the movable rod 43 to be inserted through the guide conductor through hole 411. The movable rod 43 is guided to the guide conductor through hole 411 and can thereby be linearly moved between the upper end side and the lower end side. When the high-voltage side terminal part 13 and the high-voltage side electrode 21 are electrically connected, the movable rod 43 is moved to the upper end side, and a part of the movable rod 43 is housed in the concave part 131. Thus, in the present embodiment, the high-voltage side terminal part 13 and the high-voltage side electrode 21 can reliably be connected to each other.

In the present embodiment, the eccentric member 44 is housed inside the guide conductor 41, as described above. In this state, the eccentric member 44 is peripherally surrounded by the guide conductor 41 except for a part of the guide conductor 41 where the guide conductor opening 412 is formed. Therefore, in the present embodiment, even when abnormal voltage is generated due to lightning or the like, the guide conductor 41 functions as a shield, making it possible to reduce electric filed intensity in the eccentric member 44 to less than flashover electric field intensity.

As described above, in the present embodiment, the shield lower side opening 302 of the shield 30 has the notch 302K (see FIG. 4) at a portion through which the insulating rod 45 penetrates. Thus, in the present embodiment, the insulating rod 45 can be made to penetrate through the shield lower side opening 302 without increasing the outer diameter of the shield 30.

In the present embodiment, the insulating rod 45 has the reinforcing part 451, which is made of a metal material, at a part thereof that slides with respect to the high-voltage side electrode 21. Further, at least a part of the operating rod 46 that slides with respect to the bottom plate 15 is made of a metal material. Thus, reliability of the isolating device can be enhanced.

### (Modifications)

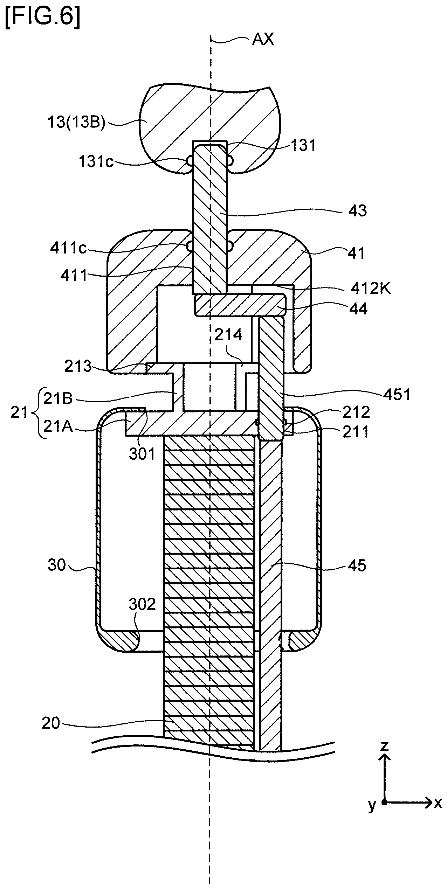

FIG 6 is a cross-sectional view illustrating the surge arrester 1 according to a modification of the embodiment. Like FIG. 3, FIG. 6 illustrates a part of the surge arrester 1 in an enlarged manner.

In the above embodiment, the guide conductor 41 is configured to peripherally surround the eccentric member 64 at a part thereof other than the part where the guide conductor opening 412 is formed, as illustrated in FIG. 3; however, the present invention is not limited to this. As illustrated in FIG. 6, a guide conductor notch 412K may be formed in place of the guide conductor opening 412, and the guide conductor 41 may be configured to surround the eccentric member 44 over the entire peripheral direction of the guide conductor 41.

Thus, when abnormal voltage is generated due to lightning or the like, the shield function of the guide conductor 41 is exhibited more prominently, making it possible to reduce electric field intensity in the eccentric member 44 more effectively.

### EXPLANATION OF REFERENCES

1...surge arrester, 10...grounded enclosure, 11...insulating spacer, 12...ring, 13...high-voltage side terminal part, 13A...first high-voltage side terminal component, 13B...second high-voltage side terminal component, 15...bottom plate, 20...nonlinear resistor, 21...high-voltage side electrode, 21A...first high-voltage side electrode part, 21B...second high-voltage side electrode part, 22 ... ground side electrode, 30...shield, 40...isolating device, 41...guide conductor, 43...movable rod, 44...eccentric member, 45...insulating rod, 46...operating rod, 47...rod operating part, 101...tank upper opening, 102...tank lower opening, 111...metal conductor, 131...concave part, 131c...first contact, 151...first bottom plate through hole, 152...second bottom plate through hole, 211...high-voltage side electrode through hole, 211...electrode through hole, 212...low-friction ring, 213...flange part, 214...high-voltage side electrode opening, 221 ...ground side terminal part, 301...shield upper side opening, 302...shield lower side opening, 302K...notch, 411 ...guide conductor through hole, 411c...second contact, 412...guide conductor opening, 451...reinforcing part, 471...first link member, 472...second link member, AX...center axis

## Claims

1. A surge arrester (1) comprising:
a grounded enclosure (10) in which insulation gas is encapsulated;
a nonlinear resistor (20) housed inside the grounded enclosure (10), having a high-voltage side electrode (21) at one end surface side of the nonlinear resistor (20);
a high-voltage side terminal part (13) installed at the one end side of the grounded enclosure (10), being electrically connected to a gas-insulation switchgear; and
an isolating device (40) configured to switch electrically connect or disconnect between the high-voltage side terminal part (13) and the high-voltage side electrode (21), wherein
the high-voltage side terminal part (13) has a concave part (131) at the one end side of the grounded enclosure (10), and
the isolating device (40) has:
a guide conductor (41) electrically connected to the high-voltage side electrode (21) inside the grounded enclosure (10), being formed such that a guide conductor through hole (411) penetrating an upper surface portion of the guide conductor (41) faces the high-voltage side terminal part (13) and is coaxial with the concave part (131) of the high-voltage side terminal part (13);
a movable rod (43) disposed coaxially with the grounded enclosure (10) and inserted through the guide conductor through hole (411), being configured to be movable between the one end side and the other end side of the grounded enclosure (10),
an insulating rod (45) disposed at an eccentric position eccentric with respect to the nonlinear resistor (20) and the movable rod (43) inside the grounded enclosure (10) ;
an eccentric member (44) connecting the movable rod (43) and the insulating rod (45) inside the grounded enclosure (10), a lower end portion of the movable rod (43) being connected to a part of an upper surface of the eccentric member (44) that is positioned at a center axis (AX) of the grounded enclosure (10), and an upper end portion of the insulating rod (45) being connected to a part of a lower surface of the eccentric member (44) that is positioned radially outside the center axis (AX) of the grounded enclosure (10); and
a rod operating part (47) installed outside the grounded enclosure (10), moving the insulating rod (45) and eccentric member (44) to move the movable rod (43) between the one end side and the other end side of the grounded enclosure (10),
the isolating device (40) moving the movable rod (43) to the one end side of the grounded enclosure (10) when the high-voltage side terminal part (13) and the high-voltage side electrode (21) are electrically connected to house a part of the movable rod (43) in the concave part (131) of the high-voltage side terminal part (13), and
the isolating device (40) moving the movable rod (43) to the other end side of the grounded enclosure (10) when the high-voltage side terminal part (13) and the high-voltage side electrode (21) are electrically disconnected to separate the movable rod (43) and the high-voltage side terminal part (13) from each other.

2. The surge arrester (1) according to claim 1, wherein
the guide conductor (41) is formed so as to surround the periphery of the eccentric member (44).

3. The surge arrester (1) according to claim 1, further comprising,
a shield (30) disposed inside the grounded enclosure (10) closer to the other end side of the grounded enclosure (10) than the guide conductor (41) is, wherein
the shield (30) has an opening through which the nonlinear resistor (20) and the insulating rod (45) penetrate, and
a notch (302K) is formed at a part of the opening where the insulating rod (45) penetrates.

4. The surge arrester (1) according to claim 1, wherein
the insulating rod (45) penetrates through an electrode through hole (211) formed in the high-voltage side electrode (21) and has a reinforcing part (451) which is made of a metal material, at at least a part thereof that slides with respect to the high-voltage side electrode (21).

5. The surge arrester (1) according to claim 1, wherein
the isolating device (40) further has an operating rod (46) connecting the insulating rod (45) and the rod operating part (47),
the operating rod (46) penetrates through a bottom plate installed at the other end side of the grounded enclosure (10), and
at least a part of the operating rod (46) that slides with respect to the bottom plate is made of a metal material.

6. The surge arrester (1) according to claim 2, further comprising, a shield (30) disposed inside the grounded enclosure (10) closer to the other end side of the grounded enclosure (10) than the guide conductor (41) is, wherein
the shield (30) has an opening through which the nonlinear resistor (20) and the insulating rod (45) penetrate, and
a notch (302K) is formed at a part of the opening where the insulating rod (45) penetrates.

7. The surge arrester (1) according to claim 2, wherein
the insulating rod (45) penetrates through an electrode through hole (211) formed in the high-voltage side electrode (21) and has a reinforcing part (451) which is made of a metal material, at at least a part thereof that slides with respect to the high-voltage side electrode (21).

8. The surge arrester (1) according to claim 2, wherein
the isolating device (40) further has an operating rod (46) connecting the insulating rod (45) and the rod operating part (47),
the operating rod (46) penetrates through a bottom plate installed at the other end side of the grounded enclosure (10), and
at least a part of the operating rod (46) that slides with respect to the bottom plate is made of a metal material.

9. The surge arrester (1) according to claim 3, wherein
the insulating rod (45) penetrates through an electrode through hole (211) formed in the high-voltage side electrode (21) and has a reinforcing part (451) which is made of a metal material, at at least a part thereof that slides with respect to the high-voltage side electrode (21).

10. The surge arrester (1) according to claim 3, wherein
the isolating device (40) further has an operating rod (46) connecting the insulating rod (45) and the rod operating part (47),
the operating rod (46) penetrates through a bottom plate installed at the other end side of the grounded enclosure (10), and
at least a part of the operating rod (46) that slides with respect to the bottom plate is made of a metal material.

11. The surge arrester (1) according to claim 4, wherein
the isolating device (40) further has an operating rod (46) connecting the insulating rod (45) and the rod operating part (47),
the operating rod (46) penetrates through a bottom plate installed at the other end side of the grounded enclosure (10), and
at least a part of the operating rod (46) that slides with respect to the bottom plate is made of a metal material.

## Patentansprüche

1. Ein Überspannungsableiter (1), aufweisend:
ein geerdetes Gehäuse (10), in dem Isoliergas eingekapselt ist;
einen nichtlinearen Widerstand (20), der innerhalb des geerdeten Gehäuses (10) untergebracht ist und eine hochspannungsseitige Elektrode (21) an einer Endflächenseite des nichtlinearen Widerstands (20) aufweist;
einen hochspannungsseitigen Anschlussteil (13), der an der einen Endseite des geerdeten Gehäuses (10) installiert ist und elektrisch mit einer gasisolierten Schaltanlage verbunden ist; und
eine Isolationsvorrichtung (40), die konfiguriert ist, um eine elektrische Verbindung oder Trennung zwischen dem hochspannungsseitigen Anschlussteil (13) und der hochspannungsseitigen Elektrode (21) zu schalten, wobei
der hochspannungsseitige Anschlussteil (13) einen konkaven Teil (131) an der einen Endseite des geerdeten Gehäuses (10) aufweist, und
die Isoliervorrichtung (40) aufweist:
einen Führungsleiter (41), der elektrisch mit der hochspannungsseitigen Elektrode (21) innerhalb des geerdeten Gehäuses (10) verbunden ist, wobei er so ausgebildet ist, dass ein Führungsleiter-Durchgangsloch (411), das durch einen oberen Oberflächenabschnitt des Führungsleiters (41) hindurchtritt, dem hochspannungsseitigen Anschlussteil (13) zugewandt ist und koaxial mit dem konkaven Teil (131) des hochspannungsseitigen Anschlussteils (13) ist;
eine bewegliche Stange (43), die koaxial zu dem geerdeten Gehäuse (10) angeordnet ist und durch das Führungsleiter-Durchgangsloch (411) eingeführt ist, wobei sie so konfiguriert ist, dass sie zwischen der einen Endseite und der anderen Endseite des geerdeten Gehäuses (10) bewegbar ist,
eine isolierende Stange (45), die an einer exzentrischen Position angeordnet ist, die exzentrisch in Bezug auf den nichtlinearen Widerstand (20) und die bewegliche Stange (43) innerhalb des geerdeten Gehäuses (10) ist;
ein exzentrisches Element (44), das die bewegliche Stange (43) und die isolierende Stange (45) innerhalb des geerdeten Gehäuses (10) verbindet, wobei ein unterer Endabschnitt der beweglichen Stange (43) mit einem Teil einer oberen Fläche des exzentrischen Elements (44) verbunden ist, der an einer Mittelachse (AX) des geerdeten Gehäuses (10) positioniert ist, und ein oberer Endabschnitt der isolierenden Stange (45) mit einem Teil einer unteren Fläche des exzentrischen Elements (44) verbunden ist, der radial außerhalb der Mittelachse (AX) des geerdeten Gehäuses (10) positioniert ist; und
einen Stangenbetätigungsteil (47), der außerhalb des geerdeten Gehäuses (10) installiert ist und die isolierende Stange (45) und das exzentrische Element (44) bewegt, um die bewegliche Stange (43) zwischen der einen Endseite und der anderen Endseite des geerdeten Gehäuses (10) zu bewegen,
die Isoliervorrichtung (40) die bewegliche Stange (43) zu der einen Endseite des geerdeten Gehäuses (10) bewegt, wenn der hochspannungsseitige Anschlussteil (13) und die hochspannungsseitige Elektrode (21) elektrisch verbunden sind, um einen Teil der beweglichen Stange (43) in dem konkaven Teil (131) des hochspannungsseitigen Anschlussteils (13) aufzunehmen, und
die Isoliervorrichtung (40) die bewegliche Stange (43) zu der anderen Endseite des geerdeten Gehäuses (10) bewegt, wenn der hochspannungsseitige Anschlussteil (13) und die hochspannungsseitige Elektrode (21) elektrisch getrennt sind, um die bewegliche Stange (43) und den hochspannungsseitigen Anschlussteil (13) voneinander zu trennen.

2. Der Überspannungsableiter (1) nach Anspruch 1, wobei
der Führungsleiter (41) so ausgebildet ist, dass er den Umfang des exzentrischen Elements (44) umgibt.

3. Der Überspannungsableiter (1) nach Anspruch 1, ferner aufweisend:
eine Abschirmung (30), die innerhalb des geerdeten Gehäuses (10) näher an der anderen Endseite des geerdeten Gehäuses (10) als der Führungsleiter (41) angeordnet ist, wobei
die Abschirmung (30) eine Öffnung aufweist, durch die der nichtlineare Widerstand (20) und die isolierende Stange (45) hindurchtreten, und
eine Kerbe (302K) an einem Teil der Öffnung ausgebildet ist, durch die die isolierende Stange (45) hindurchtritt.

4. Der Überspannungsableiter (1) nach Anspruch 1, wobei
die isolierende Stange (45) durch ein Elektrodendurchgangsloch (211), das in der hochspannungsseitigen Elektrode (21) ausgebildet ist, hindurchtritt und einen Verstärkungsteil (451), der aus einem Metallmaterial besteht, an zumindest einem Teil davon aufweist, der in Bezug auf die hochspannungsseitige Elektrode (21) gleitet.

5. Der Überspannungsableiter (1) nach Anspruch 1, wobei
die Isoliervorrichtung (40) ferner eine Betätigungsstange (46) aufweist, die die isolierende Stange (45) und den Stangenbetätigungsteil (47) verbindet,
die Betätigungsstange (46) durch eine Bodenplatte hindurchtritt, die an der anderen Endseite des geerdeten Gehäuses (10) installiert ist, und
zumindest einen Teil der Betätigungsstange (46), der in Bezug auf die Bodenplatte gleitet, aus einem Metallmaterial besteht.

6. Der Überspannungsableiter (1) nach Anspruch 2, ferner mit einer Abschirmung (30), die innerhalb des geerdeten Gehäuses (10) näher an der anderen Endseite des geerdeten Gehäuses (10) als der Führungsleiter (41) angeordnet ist, wobei
die Abschirmung (30) eine Öffnung aufweist, durch die der nichtlineare Widerstand (20) und die isolierende Stange (45) hindurchtreten, und
eine Kerbe (302K) an einem Teil der Öffnung ausgebildet ist, durch die die isolierende Stange (45) hindurchtritt.

7. Der Überspannungsableiter (1) nach Anspruch 2, wobei
die isolierende Stange (45) durch ein in der hochspannungsseitigen Elektrode (21) ausgebildetes Elektrodendurchgangsloch (211) hindurchtritt und einen Verstärkungsteil (451) aufweist, der aus einem Metallmaterial besteht, an zumindest einem Teil davon, der in Bezug auf die hochspannungsseitige Elektrode (21) gleitet.

8. Der Überspannungsableiter (1) nach Anspruch 2, wobei
die Isoliervorrichtung (40) ferner eine Betätigungsstange (46) aufweist, die die isolierende Stange (45) und den Stangenbetätigungsteil (47) verbindet,
die Betätigungsstange (46) durch eine Bodenplatte hindurchtritt, die an der anderen Endseite des geerdeten Gehäuses (10) installiert ist, und
zumindest ein Teil der Betätigungsstange (46), der in Bezug auf die Bodenplatte gleitet, aus einem Metallmaterial besteht.

9. Der Überspannungsableiter (1) nach Anspruch 3, wobei
die isolierende Stange (45) durch ein in der hochspannungsseitigen Elektrode (21) ausgebildetes Elektrodendurchgangsloch (211) hindurchtritt und an zumindest einem Teil davon, der in Bezug auf die hochspannungsseitige Elektrode (21) gleitet, einen Verstärkungsteil (451) aufweist, der aus einem Metallmaterial besteht.

10. Der Überspannungsableiter (1) nach Anspruch 3, wobei
die Isoliervorrichtung (40) ferner eine Betätigungsstange (46) aufweist, die die isolierende Stange (45) und den Stangenbetätigungsteil (47) verbindet,
die Betätigungsstange (46) durch eine Bodenplatte hindurchtritt, die an der anderen Endseite des geerdeten Gehäuses (10) installiert ist, und
zumindest ein Teil der Betätigungsstange (46), der in Bezug auf die Bodenplatte gleitet, aus einem Metallmaterial besteht.

11. Der Überspannungsableiter (1) nach Anspruch 4, wobei
die Isoliervorrichtung (40) ferner eine Betätigungsstange (46) aufweist, die die isolierende Stange (45) und den Stangenbetätigungsteil (47) verbindet,
die Betätigungsstange (46) durch eine Bodenplatte hindurchtritt, die an der anderen Endseite des geerdeten Gehäuses (10) installiert ist, und
zumindest ein Teil der Betätigungsstange (46), der in Bezug auf die Bodenplatte gleitet, aus einem Metallmaterial besteht.

## Revendications

1. Limiteur de surtension (1) comprenant :
une enceinte reliée à la terre (10) dans laquelle un gaz d'isolation est encapsulé ;
une résistance non linéaire (20) logée à l'intérieur de l'enceinte reliée à la terre (10), présentant une électrode latérale haute tension (21) sur un côté de surface d'extrémité de la résistance non linéaire (20) ;
une partie de borne latérale haute tension (13) installée sur le un côté d'extrémité de l'enceinte reliée à la terre (10), étant électriquement reliée à un appareillage de commutation par isolation au gaz ; et
un dispositif isolant (40) configuré pour relier ou ne pas relier électriquement par commutation entre la partie de borne latérale haute tension (13) et l'électrode latérale haute tension (21), dans lequel
la partie de borne latérale haute tension (13) présente une partie concave (131) sur le un côté d'extrémité de l'enceinte reliée à la terre (10), et
le dispositif isolant (40) présente :
un guide conducteur (41) électriquement relié à l'électrode latérale haute tension (21) à l'intérieur de l'enceinte reliée à la terre (10), étant formé de sorte qu'un trou traversant de guide conducteur (411) pénétrant une section de surface supérieure du guide conducteur (41) fasse face à la partie de borne latérale haute tension (13) et soit coaxial à la partie concave (131) de la partie de borne latérale haute tension (13) ;
une tige mobile (43) disposée de façon coaxiale à l'enceinte reliée à la terre (10) et insérée à travers le trou traversant de guide conducteur (411), étant configurée pour être mobile entre le un côté d'extrémité et l'autre côté d'extrémité de l'enceinte reliée à la terre (10),
une tige isolante (45) disposée en une position excentrique, excentrique par rapport à la résistance non linéaire (20) et à la tige mobile (43) à l'intérieur de l'enceinte reliée à la terre (10) ;
un élément excentrique (44) reliant la tige mobile (43) et la tige isolante (45) à l'intérieur de l'enceinte reliée à la terre (10), une section d'extrémité inférieure de la tige mobile (43) étant reliée à une partie d'une surface supérieure de l'élément excentrique (44) qui est positionnée sur un axe central (AX) de l'enceinte reliée à la terre (10), et une section d'extrémité supérieure de la tige isolante (45) étant reliée à une partie d'une surface inférieure de l'élément excentrique (44) qui est positionnée radialement à l'extérieur de l'axe central (AX) de l'enceinte reliée à la terre (10) ; et
une partie opérationnelle de tige (47) installée à l'extérieur de l'enceinte reliée à la terre (10), déplaçant la tige isolante (45) et l'élément excentrique (44) pour déplacer la tige mobile (43) entre le un côté d'extrémité et l'autre côté d'extrémité de l'enceinte reliée à la terre (10),
le dispositif isolant (40) déplaçant la tige mobile (43) vers le un côté d'extrémité de l'enceinte reliée à la terre (10) lorsque la partie de borne latérale haute tension (13) et l'électrode latérale haute tension (21) sont électriquement reliées pour loger une partie de la tige mobile (43) dans la partie concave (131) de la partie de borne latérale haute tension (13), et
le dispositif isolant (40) déplaçant la tige mobile (43) vers l'autre côté d'extrémité de l'enceinte reliée à la terre (10) lorsque la partie de borne latérale haute tension (13) et l'électrode latérale haute tension (21) sont électriquement reliées pour séparer la tige mobile (43) et la partie de borne latérale haute tension (13) l'une de l'autre.

2. Limiteur de surtension (1) selon la revendication 1, dans lequel
le guide conducteur (41) est formé de manière à entourer la périphérie de l'élément excentrique (44).

3. Limiteur de surtension (1) selon la revendication 1, comprenant en outre,
un écran (30) disposé à l'intérieur de l'enceinte reliée à la terre (10) plus proche de l'autre côté d'extrémité de l'enceinte reliée à la terre (10) que ne l'est le guide conducteur (41), dans lequel
l'écran (30) présente une ouverture à travers laquelle la résistance non linéaire (20) et la tige isolante (45) pénètrent, et
une encoche (302K) est formée en une partie de l'ouverture où pénètre la tige isolante (45).

4. Limiteur de surtension (1) selon la revendication 1, dans lequel
la tige isolante (45) pénètre à travers un trou traversant d'électrode (211) formé dans l'électrode latérale haute tension (21) et présente une partie de renforcement (451) qui est fabriquée dans un matériau métallique, au niveau d'au moins une partie de celle-ci qui coulisse par rapport à l'électrode latérale haute tension (21).

5. Limiteur de surtension (1) selon la revendication 1, dans lequel
le dispositif isolant (40) présente en outre une tige opérationnelle (46) reliant la tige isolante (45) et la partie opérationnelle de tige (47),
la tige opérationnelle (46) pénètre à travers une plaque de fond installée sur l'autre côté d'extrémité de l'enceinte reliée à la terre (10), et
au moins une partie de la tige opérationnelle (46) qui coulisse par rapport à la plaque de fond est fabriquée dans un matériau métallique.

6. Limiteur de surtension (1) selon la revendication 2, comprenant en outre, un écran (30) disposé à l'intérieur de l'enceinte reliée à la terre (10) plus proche de l'autre côté d'extrémité de l'enceinte reliée à la terre (10) que ne l'est le guide conducteur (41), dans lequel
l'écran (30) présente une ouverture à travers laquelle la résistance non linéaire (20) et la tige isolante (45) pénètrent, et
une encoche (302K) est formée en une partie de l'ouverture où pénètre la tige isolante (45).

7. Limiteur de surtension (1) selon la revendication 2, dans lequel
la tige isolante (45) pénètre à travers un trou traversant d'électrode (211) formé dans l'électrode latérale haute tension (21) et présente une partie de renforcement (451) qui est fabriquée dans un matériau métallique, au niveau d'au moins une partie de celle-ci qui coulisse par rapport à l'électrode latérale haute tension (21).

8. Limiteur de surtension (1) selon la revendication 2, dans lequel
le dispositif isolant (40) présente en outre une tige opérationnelle (46) reliant la tige isolante (45) et la partie opérationnelle de tige (47),
la tige opérationnelle (46) pénètre à travers une plaque de fond installée sur l'autre côté d'extrémité de l'enceinte reliée à la terre (10), et
au moins une partie de la tige opérationnelle (46) qui coulisse par rapport à la plaque de fond est fabriquée dans un matériau métallique.

9. Limiteur de surtension (1) selon la revendication 3, dans lequel
la tige isolante (45) pénètre à travers un trou traversant d'électrode (211) formé dans l'électrode latérale haute tension (21) et présente une partie de renforcement (451) qui est fabriquée dans un matériau métallique, au niveau d'au moins une partie de celle-ci qui coulisse par rapport à l'électrode latérale haute tension (21).

10. Limiteur de surtension (1) selon la revendication 3, dans lequel
le dispositif isolant (40) présente en outre une tige opérationnelle (46) reliant la tige isolante (45) et la partie opérationnelle de tige (47),
la tige opérationnelle (46) pénètre à travers une plaque de fond installée sur l'autre côté d'extrémité de l'enceinte reliée à la terre (10), et
au moins une partie de la tige opérationnelle (46) qui coulisse par rapport à la plaque de fond est fabriquée dans un matériau métallique.

11. Limiteur de surtension (1) selon la revendication 4, dans lequel
le dispositif isolant (40) présente en outre une tige opérationnelle (46) reliant la tige isolante (45) et la partie opérationnelle de tige (47),
la tige opérationnelle (46) pénètre à travers une plaque de fond installée sur l'autre côté d'extrémité de l'enceinte reliée à la terre (10), et
au moins une partie de la tige opérationnelle (46) qui coulisse par rapport à la plaque de fond est fabriquée dans un matériau métallique.
